# FASCICULE DE BREVET EUROPEEN

(11) **EP 3 651 185 B1**
(45) Date de publication et mention de la délivrance du brevet: **11.08.2021**
(21) Numéro de dépôt: 19207258.5
(22) Date de dépôt: 05.11.2019
(51) Int. Cl.: H01L 21/20

(54) **PROCÉDÉ DE COLLAGE AVEC DÉSORPTION STIMULÉE ÉLECTRONIQUEMENT**
BONDING-VERFAHREN MIT ELEKTRONISCH STIMULIERTER DESORPTION
BONDING METHOD WITH ELECTRONICALLY STIMULATED DESORPTION

(30) Priorité: 09.11.2018 FR 1860395
(43) Date de publication de la demande: 13.05.2020
(73) Titulaire: Commissariat à l'énergie atomique et aux énergies alternatives, 75015 Paris (FR)
(72) Inventeur: FOURNEL, Frank, 38054 GRENOBLE CEDEX 09 (FR); LARREY, Vincent, 38054 GRENOBLE CEDEX 09 (FR); MAITREJEAN, Sylvain, 38054 GRENOBLE CEDEX 09 (FR); MORALES, Christophe, 38054 GRENOBLE CEDEX 09 (FR)
(74) Mandataire: Brevalex

(56) Documents cités:
- US-A1- 2003 141 502
- "Surface activated bonding of silicon wafers at room temperature", APPLIED PHYSICS LETTERS, A I P PUBLISHING LLC, US, vol. 68, no. 16, 15 avril 1996 (1996-04-15), pages 2222-2224, XP012015052, ISSN: 0003-6951, DOI: 10.1063/1.115865
- PLOSZL A ET AL: "Wafer direct bonding: tailoring adhesion between brittle materials", MATERIALS SCIENCE AND ENGINEERING: R: REPORTS, ELSEVIER, AMSTERDAM, NL, vol. 25, no. 1-2, 10 March 1999 (1999-03-10), pages 1-88, XP004167445, ISSN: 0927-796X, DOI: 10.1016/S0927-796X(98)00017-5

## Description

### DOMAINE TECHNIQUE

Le domaine de l'invention est celui du collage direct de substrats. L'invention concerne plus particulièrement un collage direct pouvant être obtenu à température ambiante et ne nécessitant pas de recuit post-collage visant à renforcer l'énergie du collage.

### ÉTAT DE LA TECHNIQUE ANTÉRIEURE

La technique du collage direct consiste à mettre en contact intime des surfaces suffisamment propres et lisses pour qu'une adhésion entre elles puisse se réaliser. Il est ainsi possible d'assembler des substrats sans apport de matière supplémentaire et notamment sans adhésif.

Si dans le domaine du collage direct, il existe de nombreuses techniques de préparation de surface et de collage, il est en général toujours nécessaire, après l'étape de collage opérée à température ambiante, de réaliser un recuit pour renforcer l'énergie d'adhésion des surfaces mises en contact.

La technique de collage avec activation de surface (dite SAB pour « Surface Activated Bonding ») permet en revanche d'obtenir une énergie d'adhésion dès la température ambiante. Cette technique consiste à bombarder sous vide poussé les surfaces à coller par des ions, par exemple des ions d'argon. Le bombardement ionique permet de retirer l'oxyde de surface et d'enlever les contaminants organiques. Le vide poussé permet d'éviter que l'oxyde de surface ne se reforme.

Cette technique fonctionne très bien avec les matériaux semi-conducteurs comme le silicium ou le germanium car le bombardement ionique permet de retirer les contaminants de surface et l'oxyde natif tout en laissant en surface des liaisons pendantes qui permettent une adhésion très importante sans recuit thermique. Mais du fait de l'activation, des ions d'argon s'implantent dans la surface et viennent endommager la maille cristalline ce qui engendre une amorphisation superficielle.

Afin de réduire la couche amorphe résultant de l'activation, il a été proposé d'utiliser des atomes plus petits que l'argon, comme l'hélium. Mais le décapage de la surface pour l'obtention des liaisons pendantes est alors moins efficace. La tendance est désormais d'utiliser des atomes plus lourds que l'argon, comme le néon par exemple, voire même d'utiliser des amas d'atomes pour la technique GCIB (pour « Gas Cluster Ion Beam »). Cette dernière technique ne permet cependant pas de traiter une grande surface, comme celle d'un substrat de 200 mm de diamètre, en un temps raisonnable.

Les documents suivants décrivent des techniques de liaison directe connues dans l'art:
US 2003/141502 A1,
"Surface activated bonding of silicon wafers at room temperature",APPLIED PHYSICS LETTERS, A IP PUBLISHING LLC, US, vol. 68, no. 16, 15 avril 1996 (1996-04-15), pages 2222-2224, et
PLOSZL A ET AL: "Wafer direct bonding: tailoring adhésion between brittle materials",MATERIALS SCIENCE AND ENGINEERING: R: REPORTS, ELSEVIER, AMSTERDAM, NL, vol. 25, no. 1-2, 10 mars 1999 (1999-03-10), pages 1-88.

### EXPOSÉ DE L'INVENTION

L'invention a pour objectif de proposer une technique de collage direct qui, comme le collage SAB, ne nécessite pas de recuit de renforcement post-collage et qui, au contraire du collage SAB, ne s'accompagne pas de la formation d'une couche amorphe.

A cet effet, l'invention propose un procédé de collage direct d'un premier et d'un deuxième substrat, comprenant :
- un retrait de couches d'oxyde en surface de faces de collage du premier et du deuxième substrat ;
- une passivation par des liaisons hydrogène des faces de collage; et
- sous vide, une désorption d'hydrogène par impact électronique sur les faces de collage suivie d'une mise en contact intime des faces de collage.

Certains aspects préférés mais non limitatifs de ce procédé sont les suivants :
- le retrait est réalisé par voie chimique ;
- le retrait et la passivation sont réalisés simultanément ;
- le retrait et la passivation sont réalisés au moyen d'une solution d'acide fluorhydrique ;
- lors de la désorption d'hydrogène par impact électronique, les premier et deuxième substrats sont chacun agencés sur un support électriquement conducteur ;
- un contact électrique relie la face de collage de l'un des premier et deuxième substrats à son support ;
- l'impact électronique réalise un impact de 10¹⁴ à 10¹⁹ électrons/cm².
- l'impact électronique présente une énergie comprise entre 0,01 et 100 kEv et une intensité comprise entre 0,01 et 1000 µA/cm² ;
- l'impact électronique sur l'une des faces de collage comprend un balayage d'un faisceau d'électrons réalisé de manière à irradier l'intégralité de la face de collage une pluralité de fois ;
- les faces de collage mises en contact intime sont maintenues sous pression.

D'autres aspects, buts, avantages et caractéristiques de l'invention apparaîtront mieux à la lecture de la description détaillée suivante de formes de réalisation préférées de celle-ci, donnée à titre d'exemple non limitatif.

### EXPOSÉ DÉTAILLÉ DE MODES DE RÉALISATION PARTICULIERS

L'invention porte sur un procédé de collage direct d'un premier et d'un deuxième substrat. Les substrats peuvent être en matériau semi-conducteur, par exemple en silicium ou en germanium.

Le procédé selon l'invention comprend de préférence une étape préalable de nettoyage des premier et deuxième substrats pour les débarrasser d'éventuelles contaminations organiques ou particulaires.

Ce procédé comprend un retrait de couches d'oxyde en surface de faces de collage du premier et du deuxième substrat et une passivation par des liaisons hydrogène des faces de collage chacune débarrassée de sa couche d'oxyde respective. Le retrait peut être réalisé par voie chimique. Le retrait et la passivation peuvent être réalisés simultanément, par exemple au moyen d'une solution d'acide fluorhydrique. Le retrait et la passivation peuvent alternativement être réalisés séquentiellement, par exemple en réalisant le retrait au moyen d'un recuit à haute température (typiquement à plus de 700°C) sous ultra vide et en réalisant la passivation au moyen d'une mise sous pression partielle d'hydrogène (typiquement à plus de 0.01mbar).

Après le retrait et la passivation, chacun des substrats est placé dans une chambre de désorption d'une enceinte sous vide, typiquement à moins de 10⁻⁶ mbar et de préférence à moins de 10⁻⁸ mbar. Le procédé se poursuit avec la réalisation, dans chacune des chambres de désorption, d'une désorption d'hydrogène par impact électronique sur la face de collage d'un substrat. La face de collage de chacun des substrats est ainsi soumise à un bombardement d'électrons selon la technique dite ESD pour « Electron Stimulated Desorption » pour y retirer les atomes d'hydrogène et y laisser des liaisons pendantes permettant ultérieurement un collage de forte énergie.

Lors de la désorption d'hydrogène par impact électronique, les premier et deuxième substrats peuvent chacun être agencé sur un support électriquement conducteur. De telle manière, il s'avère possible de résoudre les problématiques de charge qui peuvent apparaître pendant le traitement d'une surface de grande superficie du fait que les électrons ne peuvent être neutralisés. Dans une réalisation possible trouvant avantageusement application pour des substrats du type semiconducteur sur isolant SeOI (pour « Semiconductor On Insulator »), un contact électrique relie la face de collage d'un substrat à son support.

Lors de la désorption d'hydrogène par impact électronique sur une face de collage, un faisceau d'électrons peut venir bombarder la face de collage pour atteindre une dose bombardée de 10¹⁴ à 10¹⁹ électrons/cm², de préférence de 10¹⁴ à 10¹⁸ électrons/cm². Les électrons peuvent présenter une énergie comprise entre 0,01 et 100 kEv, de préférence entre 0,1 et 10 keV, et une intensité comprise entre 0,01 et 1000 µA/cm², de préférence entre 1 et 100 µA/cm². Si le faisceau n'est pas assez large pour couvrir toute la face de collage, il est alors balayé pour que l'impact électronique couvre l'intégralité de la face de collage. Si nécessaire pour atteindre la dose d'intérêt, le balayage du faisceau d'électrons est réalisé de manière à irradier l'intégralité de la face de collage une pluralité de fois. A titre d'exemple, la dose d'intérêt peut être atteinte en moins de 5 minutes.

Après le traitement ESD de la face de collage de chacun des substrats, les substrats sont transférés dans une chambre de collage de l'enceinte sous vide. Le procédé comprend alors la mise en contact intime des faces de collage. Les faces de collage mises en contact intime sont de préférence maintenues sous pression, par exemple avec une pression allant de 0,01 à 5 MPa, de préférence avec une pression allant de 0,1 à 1 MPa, et pendant une durée typiquement comprise entre 5 secondes et 60 minutes, préférentiellement 1 minute. L'assemblage formé des deux substrats collés par l'intermédiaire des faces de collage est ensuite ressorti de l'enceinte sous vide.

Un exemple de mise en œuvre du procédé selon l'invention est le suivant. Deux substrats de silicium, d'orientation <001>, de 200mm de diamètre, de 725µm d'épaisseur et ayant une résistivité de 10 ohm/cm sont nettoyés avec une solution d'eau déionisée additionnée de 30ppm d'ozone, suivie d'un nettoyage avec une solution SC1 (« Standard Clean 1 ») à base d'eau déionisée, d'ammoniaque et d'eau oxygénée dans des proportions 5 :1:1. Les substrats sont soumis à une désoxydation avec une solution à base de HF 1% qui engendre la passivation à l'hydrogène des faces de collage. Après rinçage à l'eau déionisée et séchage, les deux substrats sont chacun placés dans une chambre sous ultra vide à 10⁻⁸mbar où ils sont chacun agencés sur un porte-substrat conducteur relié à la masse.

Un faisceau d'électrons de 1cm² balaye la surface de chacun des substrats à une vitesse de 10cm par seconde. En 40 secondes environ, l'ensemble de la surface est balayée. Le faisceau d'électrons présente une énergie de 10 kEv et une intensité 200 µA. En balayant 10 fois la surface de chacun des substrats, on obtient une dose d'environ 10¹⁵ électrons/cm². Après le traitement ESD des deux substrats réalisé de façon simultanée dans les deux chambres, les substrats sont transférés dans une chambre de collage. Les deux faces traitées sont mises en vis-à-vis et contactées. Une force de 0.2MPa est appliquée pendant 1 minute. L'assemblage résultant du collage est ensuite ressorti de l'enceinte sous ultra vide.

## Revendications

1. Procédé de collage direct d'un premier et d'un deuxième substrat, comprenant :
- un retrait de couches d'oxyde en surface de faces de collage du premier et du deuxième substrat ;
- une passivation par des liaisons hydrogène des faces de collage: et
**caractérisé en ce que**
- sous vide, une désorption d'hydrogène par impact électronique sur les faces de collage suivie d'une mise en contact intime des faces de collage.

2. Procédé selon la revendication 1, dans lequel le retrait est réalisé par voie chimique.

3. Procédé selon la revendication 2, dans lequel le retrait et la passivation sont réalisés simultanément.

4. Procédé selon la revendication 3, dans lequel le retrait et la passivation sont réalisés au moyen d'une solution d'acide fluorhydrique.

5. Procédé selon l'une des revendications 1 à 4, dans lequel lors de la désorption d'hydrogène par impact électronique, les premier et deuxième substrats sont chacun agencés sur un support électriquement conducteur.

6. Procédé selon la revendication 5, dans lequel un contact électrique relie la face de collage de l'un des premier et deuxième substrats à son support.

7. Procédé selon l'une des revendications 1 à 6, dans lequel l'impact électronique réalise un impact de 10¹⁴ à 10¹⁹ électrons/cm².

8. Procédé selon la revendication 7, dans lequel l'impact électronique présente une énergie comprise entre 0,01 et 100 kEv et une intensité comprise entre 0,01 et 1000 µA/cm².

9. Procédé selon l'une des revendications 1 à 8, dans lequel l'impact électronique sur l'une des faces de collage comprend un balayage d'un faisceau d'électrons réalisé de manière à irradier l'intégralité de la face de collage une pluralité de fois.

10. Procédé selon l'une des revendications 1 à 9, dans lequel les faces de collage mises en contact intime sont maintenues sous pression.

## Patentansprüche

1. Verfahren zum direkten Bonden eines ersten und eines zweiten Substrats, umfassend:
- Entfernen von Oxidschichten an der Oberfläche von Bondflächen des ersten und des zweiten Substrats; und
- Passivieren der Bondflächen durch Wasserstoffbindungen;
**dadurch gekennzeichnet, dass**
- im Vakuum eine Desorption von Wasserstoff durch Elektronenstoß an den Bondflächen erfolgt, der ein inniger Kontakt der Bondflächen folgt.

2. Verfahren nach Anspruch 1, wobei das Entfernen chemisch erfolgt.

3. Verfahren nach Anspruch 2, wobei das Entfernen und das Passivieren gleichzeitig erfolgen.

4. Verfahren nach Anspruch 3, wobei das Entfernen und das Passivieren unter Verwendung einer Flusssäurelösung erfolgen.

5. Verfahren nach einem der Ansprüche 1 bis 4, wobei während der Desorption von Wasserstoff durch Elektronenstoß das erste und das zweite Substrat jeweils auf einem elektrisch leitenden Träger angeordnet sind.

6. Verfahren nach Anspruch 5, wobei ein elektrischer Kontakt die Bondfläche eines aus erstem und zweitem Substrat mit seinem Träger verbindet.

7. Verfahren nach einem der Ansprüche 1 bis 6, wobei der Elektronenstoß einen Stoß von 10¹⁴ bis 10¹⁹ Elektronen/cm² erreicht.

8. Verfahren nach Anspruch 7, wobei der Elektronenstoß eine Energie zwischen 0,01 und 100 kEv und eine Intensität zwischen 0,01 und 1000 µA/cm² hat.

9. Verfahren nach einem der Ansprüche 1 bis 8, wobei der Elektronenstoß auf einer der Bondflächen das Abtasten mit einem Elektronenstrahl umfasst, das so durchgeführt wird, dass die gesamte Bondfläche mehrmals bestrahlt wird.

10. Verfahren nach einem der Ansprüche 1 bis 9, wobei die in innigen Kontakt gebrachten Bondflächen unter Druck gehalten werden.

## Claims

1. A method for directly bonding a first substrate having a first bonding face and a second substrate having a second bonding face, comprising the steps of:
- removing a surface oxide layer from each of the first and second bonding faces;
- hydrogen passivating each of the first and second bonding faces; and being
**characterized in that**
- in a vacuum, performing electron impact hydrogen desorption on the each of the first and second bonding faces followed by placing the first and second bonding faces in intimate contact with one another.

2. The method according to claim 1, wherein the step of removing is carried out chemically.

3. The method according to claim 2, wherein the steps of removing and of hydrogen passivating are carried out simultaneously.

4. The method according to claim 3, wherein the steps of removing and of hydrogen passivating are carried out using a solution of hydrofluoric acid.

5. The method according to claim 1, wherein during the step of performing electron impact hydrogen desorption, each of the first and second substrates is arranged on an electrically conducting support.

6. The method according to claim 5, wherein an electrical contact connects the first or second bonding face to the support on which is respectively arranged the first or second substrate.

7. The method according to claim 1, wherein the step of performing electron impact hydrogen desorption is made so as to produce an impact of 10¹⁴ to 10¹⁹ electrons/cm²;

8. The method according to claim 7, wherein the step of performing electron impact hydrogen desorption is made with an energy of the electron impact which lies in the range 0.01 to 100 kEv and with an intensity which lies in the range 0.01 to 1,000 µA/cm².

9. The method according to claim 1, wherein the step of performing electron impact hydrogen desorption on one of the first and second bonding faces comprises sweeping by an electron beam so as to irradiate the entire one of the first or second bonding face a plurality of times.

10. The method according to claim 1, further comprising the step of maintaining under pressure the first and second bonding faces placed in intimate contact with one another.
